(19) Europäisches Patentamt
European Patent Office
Office européen des brevets

(11) Publication number: 0 241 770 B1

(12) # EUROPEAN PATENT SPECIFICATION

(45) Date of publication of patent specification: **29.07.92**

(51) Int. Cl.[5]: **G01R 33/06**, G11B 5/39

(21) Application number: **87104313.9**

(22) Date of filing: **24.03.87**

The file contains technical information submitted after the application was filed and not included in this specification

(54) **A circuit for biasing a magnetoresistive sensor and amplifying signals produced thereby.**

(30) Priority: **14.04.86 US 851649**

(43) Date of publication of application:
**21.10.87 Bulletin 87/43**

(45) Publication of the grant of the patent:
**29.07.92 Bulletin 92/31**

(84) Designated Contracting States:
**AT BE CH DE ES FR GB IT LI NL SE**

(56) References cited:
**DE-A- 3 308 352**

**elektronik industrie, 4-1974, p. 76-78**

(73) Proprietor: **International Business Machines Corporation**
**Old Orchard Road**
**Armonk, N.Y. 10504(US)**

(72) Inventor: **Klaassen, Klaas Berend**
**7171 Anjou Creek Circle**
**San Jose California 95120(US)**
Inventor: **Jove, Stephen Alan**
**401 Elkhorn Road**
**Watsonville California 95076(US)**

(74) Representative: **Blakemore, Frederick Norman**
**IBM United Kingdom Limited Intellectual Property Department Hursley Park**
**Winchester Hampshire SO21 2JN(GB)**

**EP 0 241 770 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a circuit for biasing a magnetoresistive sensor and amplifying signals produced thereby.

Most existing magnetoresistive (MR) sensors, including particularly sensors for bubble memories and magnetic recording, are biased at a constant bias current by preamplifiers which detect the signal voltage developed at the sensor terminals. Since stripe height is inversely proportional to sensor resistance, and varies from sensor to sensor owing to production variations and varies over the life of the sensor in contact recording applications owing to wear, it is desirable to detect signals produced by the sensor which are independent of stripe height. Thus, it is desirable to detect and amplify a voltage representing $\Delta R_h/R_h$, where $\Delta R_h$ is the change in MR sensor resistance, $R_h$, arising from the magnetic input signal from the media being read.

Prior art document EP -A- 215270 relevant under Art.54(3) EPC, discloses a circuit comprising a bias current source coupled to a magnetoresistive element to produce a current therethrough having a constant time average value and means for detecting and amplifying the instantaneous value $I_S$ of current deviations from the constant time average value substantially in accordance with the relationship:

$$I_s = I_b \frac{\Delta R_h}{R_h}$$

where $I_b$ is the current provided by the bias current source, $R_h$ is the absolute resistance of the magnetoresistive element, and $\Delta R_h$ is the instantaneous value of the change in the resistance of the magnetoresistive element in the presence of the magnetic field.

DE-A-33 08 352 from which the preamble of present Claim 1 derives describes magnetic detection apparatus comprising a first magnetoresistive sensor exposed to an external magnetic field and a second magnetoresistive sensor exposed to both the external magnetic field, and a desired signal magnetic field. A differential amplifier means is provided with a negative feedback loop for feeding back an output signal from the first sensor so as to cancel the external magnetic field component applied to the second sensor. The differential amplifier means thereby enables the signal magnetic field to be detected separately from any external magnetic fields.

The application of negative feedback to differential amplifier circuits for preventing transient instability is well known in the art. It is also well known that many such negative feedback techniques reduce the frequency response bandwidth of such amplifiers.

In accordance with the present invention, there is now provided a circuit comprising a first constant current source to supply a bias current to a magnetoresistive sensor, and amplifier means having an input stage responsive to the current flowing through the sensor to produce by output means an amplified output signal representing the change in resistance of the sensor arising from the changes in the magnetic field to which the sensor is exposed, and feedback means, characterised in that the feedback means are coupled to the input stage and the output means for adjusting the frequency response of the circuit, wherein the input stage comprises at least two transistors coupled in a first differential pair configuration and having the sensor coupled between the emitter of one of the pair of transistors and the first constant current source, the emitter of the other transistor also being coupled to the first constant current source, and in that the output means comprises at least two transistors coupled in a second differential pair configuration, the respective collectors of these transistors being coupled to the respective bases of the transistors of the first differential pair for correcting voltage level variations at the bases of the transistors of said first differential pair, and first and second follower transistors coupled to the respective collectors of the transistors of said first differential pair, for coupling voltage level variations produced in the input stage to the second differential pair, thus substantially eliminating any DC offset voltage in the amplified output signal.

In a preferred embodiment of the present invention, an enhanced transimpedance amplifier is used for biasing and amplifying the signals produced by an MR read sensor. Electrically, the resistance, $R_h$, of the MR sensor is disposed as degenerative feedback in the emitter circuit of a differential pair comprising the input stage of the amplifier. In this circuit configuration, a signal representing $\Delta R_h/R_h$ is sensed and amplified as a current through the MR sensor.

Bias current for the MR sensor is supplied by the same constant current source that supplies current to both transistors comprising the input stage of the amplifier. To correct for direct current (DC) offset arising from variations in input stage transistor characteristics and the steady-state value of $R_h$, DC feedback to the input stage, via a level shift and amplifying stage, balances current flow in both paths of the differential input stage. It should be noted that the steady-state value of $R_h$ refers to the resistance value of $R_h$ while biased but not sensing magnetic field variations.

In addition, a feed forward current source, which injects an offset current into the last-mentioned DC feedback loop, may be used to correct for the DC error at the output of the amplifier. The amount of current can be selected to eliminate the error for nominal values of steady-state sensor resistance $R_h$, and to minimise the error in the general case. It should be noted that nominal, in regard to the value of $R_h$, refers to that steady-state value of $R_h$ most often occurring in production quantities.

The input stage of the amplifier may be replicated as many times as there are MR sensors in a given system. The remaining components of the amplifier comprise the output and feedback stages which are common to all, and switched among, the input stages in a multiple-head system.

The sensitivity of the amplifier to $\Delta R_h/R_h$ signals may be increased and the sensitivity to variations in $R_h$ may be decreased by additional circuitry. Further additional circuitry may be added to shorten settling time when MR sensors having different steady state resistance values, $R_h$, are activated and deactivated in a multiple sensor system.

How the invention can be carried out will now be described by way of example, with reference to the accompanying drawings, in which:-

Fig. 1 is a block diagram of a circuit embodying the invention;

Fig. 2A is a circuit diagram corresponding to the block diagram of Fig. 1;

Fig. 2B is a block diagram indicating the coupling of input stages to the common stage of the amplifier;

Fig. 3 is a circuit diagram for enhancing $\Delta R_h/R_h$ sensitivity of the amplifier in Fig. 2A;

Fig. 4 is a circuit diagram for improving transient response of the amplifier in Fig. 2A when switched between MR sensors having different resistance;

Fig. 5 is a block diagram of elements for reducing the settling time of the amplifier in Fig. 2A when MR sensors having different resistance are activated and deactivated in a multiple-sensor system;

Fig. 6 is a circuit diagram corresponding to Fig. 5; and

Fig. 7 is a diagram of a circuit emboding the enhancements of Figs. 4 and 6.

Referring first to Fig. 1, input I from an MR sensor is applied to summer 11 of amplifier 10. Since $\Delta R_h$ is proportional to the resistance value Of $R_h$, the output signal can be made independent of variations in the value of $R_h$ arising from variations in stripe height and length by dividing the total gain of the system by $R_h$. Thus, the forward transfer function of gain stage 12 is G divided by $R_h$. The reverse transfer function, H, of feedback network 14 can be modified by setting dominant low frequency poles, Pd, in a low pass configuration to produce a high pass characteristic of the system at the output, O. The high pass characteristic is obtained by subtracting error signal, E, produced by network 14, from the input, I, at summer 11. Finally, feed forward correction, F, from source 15 for correcting DC offset at output 0 is introduced at summer 13.

The input I contains an undesirable DC component arising from the voltage drop across the sensor caused by the bias current. This DC component may create an error at output O. Therefore, subtracting the nominal value of the DC component in I from the input to the forward gain Path ($G/R_h$) eliminates the error in output O for the nominal values of $R_h$, and significantly reduces the error in output O for the general case of $R_h$ values at or near the tolerance limit of acceptable values thereof.

The concept of Fig. 1 may be implemented as shown in Fig. 2A. Bias current, $I_b$, for the MR sensor, $R_h$, is supplied by current source J1. Initially, the current through input devices T1 and T2 may be different and will cause an output offset across R1 and R2. Voltage followers T5 and T6, each coupled to constant current sources J3 and J4, respectively, shift the DC potential of this offset and apply it to feedback differential pair, T7 and T8. Thus, the voltage at the bases of input devices T1 and T2 is corrected so that one-half of the current from current source J1 flows in each input device T1 and T2. The current supplied by constant current source J1 is approximately $2I_b$.Differential pair, T7 and T8, are supplied with current by constant current source J2.

Since input devices T1 and T2 have inherently low input impedance at their emitters, the circuit is a transimpedance amplifier. In addition, $R_h$ acts as a degenerative feedback resistor. Thus, $\Delta R_{h/}R_h$ is sensed as a current through $R_h$.

Referring now also to Fig. 2B, nodes n1, n2 and n3 and NF1 and NF2 define common nodes joining separate circuits. The first circuit, comprising input devices T1 and T2, $R_h$ and current source J1, is the basic input stage for each MR sensor. The remaining components shown in Fig. 2A comprise the output and feedback stages, hereafter collectively referred to as $g_0$, which are common to two or more basic input stages. Thus, each MR sensor, $R_{h1}$, $R_{h2}$ ... $R_{hn}$, has a separate input stage, $g_1$, $g_2$, ... $g_n$' which can be activated or deactivated by activating or deactivating their respective current sources, J1.

With continuing reference to Fig. 2A, capacitor C, coupled between the bases of T1 and T2, is used to produce a dominant low frequency pole as indicated in Fig. 1 The location of the pole is determined by the value of C, R5, R6 and the loop gain, i.e. $GH/R_h$. Current source J0 injects a feed-forward offset current into the feedback loop to balance the collector voltages of output cascade pair T3 and T4 for nominal MR resistance, $R_h$, and minimises such output offset in the general case for a range of steady-state values of $R_h$.

The values of resistors R1, R2, R3, R4, R5, R6, R7 and R8 are selected to provide suitable voltage biasing for their respective active devices. Furthermore, the circuit of Fig. 2A is particularly well-suited to implementation in any number of different integrated circuit technologies, since only one capacitor, which could be an off-chip component, is required.

The output voltage, $V_{out}$, of the amplifier is related to the input impedance, $R_{in}$, as seen by $R_h$ as given below,

$$V_{out} \ \alpha \ \frac{\Delta R_h I_b}{R_{in} + R_h}$$

Therefore,

$$V_{out} \ \alpha \ \frac{\Delta R_h}{Rh} I_b \text{ as } R_{in} \to 0.$$

Thus, the lower the value of $R_{in}$, the less sensitive $V_{out}$ will be to a wider range of variation sin the steady-state value of $R_h$.

For assuring very low input impedance, $R_{in}$, presented to the MR sensor, $R_h$, the amplifier may include the compound input stage of Fig. 3. The circuit of Fig. 3 includes additional current sources J5 and J6, which are common to all input stages. Transistors $T_{11}$, $T_{12}$, $T_9$, $T_{10}$, and diodes $D_1$ and $D_2$ are all repeated for each input stage. Then, additional nodes separating the common from the repeated parts of the circuit are identified at N4, N5, N6 and N7.

Wide-band performance for the circuit of Fig. 2A is desirable and obtainable by 1) setting the dominant low frequency pole for good low frequency response, and 2) by adding a cascaded common-base stage comprising $T_3$, $T_4$ and $V_1$ for good high frequency response. However, too much recovery time is required for stabilising such a circuit when switching over from one sensor to another, i.e. deactivating one sensor and associated input stage and activating another. Obviously, if the forward gain G were increased, the dominant low frequency pole would move up in frequency and recovery time would decrease. Since that solution is undesirable for overall performance, a circuit is included for moving the dominant low frequency pole only during switchover.

The circuit for Fig. 4 comprises a non-linear feedback loop which improves the transient response of the circuit of Fig. 2A when successively switching over input stages having different values of $R_{h.}$ Diodes D9 and D10, resistor $R_7$ and current source J9 comprise additions to the common output/feedback stage of Fig. 2A. These last-mentioned components produce higher gain for reverse transfer function network 14, shown in Fig. 1, for large error signals. In particular, as the impedance of diodes D9 and D10 decreases with increasing current therethrough, the degenerative resistance in the emitter circuit of the differential pair T7 and T8 is further reduced for large input signals. Thus, the dominant low frequency pole, Pd, tends to move up in frequency for a faster transient response in accordance with the relation

$$O/I = [(1/Ho)(s + Pd)]/[R_h/GHo)(s + Pd) + 1] \quad (1)$$

where Ho = DC gain of the reverse path of the feedback loop, s = Laplace operator, Pd = dominant pole, $R_h$ = sensor resistance and G = the uncorrected gain of the forward path of the feedback loop. In accordance with Equation (1), as the error signal approaches the steady state value, the low frequency pole tends to move back to the initial frequency for good low frequency response at output 0.

Fig. 5 illustrates the principle of a non-linear feedback loop for reducing the time required for the amplifier to settle into steady-state operation after one input stage is deactivated and another is activated. The non-linear feedback loop is active only during part of the transition time when switching between input stages. While active, this feedback loop introduces additional current to capacitor C to reduce the relatively long charge and discharge times thereof, which current is otherwise limited by its value and the charging current supplied by current source J2 as shown in Fig. 2A.

With continuing reference to Figs. 2B and 5, when $R_{h1}$ is biased for steady-state operation, the voltage across capacitor C is fixed and maintained by feedback. If $R_{h1}$ is then deactivated and $R_{h2}$ is activated, where $R_{h2}$ is greater than $R_{h1}$, then a DC offset voltage appears at the output, $V_0$. Employing

preselectable hysteresis in comparator CM2, if $V_0$ then exceeds V ref by $V_{on}$, then comparator CM2 activates current source J11. Capacitor C is quickly charged to its new bias voltage because current source J11 temporarily provides substantially greater current than the charging current of $G_1$ (i.e., current source J2 as shown in Fig. 2A). When the new steady-state operating voltage is achieved, the DC offset at $V_0$ is decreased. When the DC offset $V_0$ is decreased below $V_{off}$, which is less than $V_{on}$, then comparator CM2 deactivates current source J11 and the linear feedback loop comprising $G_1$, $G_2$ and the input stage further reduces any residual offset at $V_0$. Likewise, if sensor $R_{h2}$ is switched off and new sensor $R_{h3}$ is switched on, where $R_{h3}$ is less than $R_{h2}$, comparator CM1 will operate to discharge capacitor C with current source J10.

The voltage level $V_{on}$ is selected so that noise or other device parameter variations do not cause activation of comparators CM1 or CM2 while, at the same time, allowing operation of the comparators for small differences between activated and deactivated MR sensors. The voltage level $V_{off}$ is selected so that the comparators will not switch off too soon to provide minimum transient response of the amplifier while providing an adequate margin of loop stability.

Referring now to Fig. 6, the basic input and common output feedback stages of Fig. 3 are coupled to an implementation of the non-linear feedback loop of Fig. 5. Separate reference voltages are derived from resistor dividers R22/R23 and R24/R25 to minimise interaction between the two comparators. Comparator CM2 comprises transistors T28, T30, T14, T16, T18 and T20. Diode D12 is used as a voltage level shifter.

During steady-state operation T28 is kept on (i.e. actively conducting current) by T14. The voltage developed across R20 is $V_{on}$. As the voltage at the base of T28 decreases and T30 turns on, T30 is kept on by T20. The voltage developed across R22 and R23 from T20 is equivalent to $V_{off}$. Diode D4 is used as a voltage level shifter for T8.

When the non-linear feedback loop is activated, transistor T22 supplies current to diodes D6 and D8. The base of T24 and thus, one side of capacitor C is thereby clamped to a fixed voltage. At the same time, T26 will charge capacitor C toward the new steady-state voltage level in minimum time. Since diodes D6 and D8 represent a high impedance when current through them is small and a low impedance when through them is large, the feedback loop is inherently non-linear for decreasing MR sensor switchover recovery time.

A circuit for moving the dominant low frequency pole up in frequency while concurrently increasing available charge and discharging current to capacitor C is shown in Fig. 7. The circuit comprises a transconductance amplifier in a feedback loop in lieu of comparators, voltage reference levels and selectable voltage differences required by the circuits of Figs. 4 and 6. In the circuit of Fig. 7, the current supplied from current source J12 is set to a low value for steady-state operation. the current, in turn, sets the value of the current flowing in transistors T7, T8, T32 and T33 to a value $I_{c1}$. Current $I_{c1}$ also flows through transistors T15 and T16 and transistors T13 and T14 and therefore becomes the current available to charge capacitor C. If $I_{c1}$ were increased to a value $I_{ch}$ at the moment of switchover, then both the available charge current to capacitor C and the loop gain would increase, thereby reducing capacitor charge time and moving the dominant low frequency pole up in frequency, respectively. After sufficient time for recovery has passed, the current supplied by current source J12 may be decreased to the initial value, $I_{c1}$, for steady-state operation. The rate of increase of current $I_{c1}$ to $I_{ch}$ can be controlled for smooth transition between switchover operation and steady-state operation of the circuit.

## Claims

**1.** A circuit comprising a first constant current source (J1) to supply a bias current to a magnetoresistive sensor ($R_h$), and amplifier means (11,12,13,14) having an input stage (11,13) responsive to the current flowing through the sensor ($R_h$) to produce by output means an amplified output signal representing the change in resistance of the sensor ($R_h$) arising from the changes in the magnetic field to which the sensor ($R_h$) is exposed, and feedback means (14),

characterised in that the feedback means (14) are coupled to the input stage (11,13) and the output means (12) for adjusting the frequency response of the circuit, wherein the input stage (11,13) comprises at least two transistors (T1,T2) coupled in a first differential pair configuration and having the sensor ($R_h$) coupled between the emitter of one (T2) of the pair of transistors (T1,T2) and the first constant current source (J1), the emitter of the other transistor (T1) also being coupled to the first constant current source (J1),

and in that the output means (12) comprises at least two transistors (T7,T8) coupled in a second differential pair configuration, the respective collectors of these transistors (T7,T8) being coupled to the respective bases of the transistors (T1, T2) of the first differential pair for correcting voltage level variations at the bases of the transistors (T1,T2) of said first differential pair, and first and second follower transistors (T5,T6) coupled to the respective collectors of the transistors (T1,T2) of said first differential pair, for coupling voltage level variations produced in the input stage (11,13) to the second differential pair, thus substantially eliminating any DC offset voltage in the amplified output signal.

**2.** A circuit as claimed in Claim 1, wherein the input stage (11,13) comprises means (11) for subtracting an error signal produced by the feedback means (14) from a signal representing the current flowing through the sensor ($R_h$).

**3.** A circuit as claimed in Claim 1 or Claim 2, wherein the second differential pair feeds forward a signal to the input stage (11,13).

**4.** A circuit as claimed in any preceding claim, wherein the input stage comprises means for dividing the signal representing the current flowing through the sensor ($R_h$) by a signal representing the steady state resistance of the sensor ($R_h$).

**5.** A circuit as claimed in Claim 1 wherein the current provided by the first constant current source (J1) has a constant time average value, and the transistors (T1,T2) of the first differential pair amplify current deviations from the constant time average value of the current flowing through the sensor ($R_h$).

**6.** A circuit as claimed in Claim 5, wherein said second differential pair (T7,T8) is coupled to a second constant current source (J2), and said follower transistors (T5,T6) are coupled to third and fourth constant current sources (J3,J4) respectively.

**7.** A circuit as claimed in Claim 6, including a plurality of input stages (g1,g2) coupled to selection means for activating an individual one of the plurality of input stages and deactivating all of the remaining input stages.

**8.** A circuit as claimed in Claim 7, including transient suppression means for suppressing transients produced by deactivating one and activating another of the plurality of input stages.

**9.** A circuit as claimed in Claim 7 or Claim 8, wherein the transient suppression means comprises:

a fifth constant current source (J9) coupled to the emitter of one of said differential pair (T7,T8); and

a resistor (R7) and first and second diodes (D9,D10), each coupled in parallel to each other and between the second (J2) and a fifth (J9) constant current source, the cathode of the first diode (D10) and the anode of the second diode (D9) being coupled to the fifth constant current source (J9).

**10.** A circuit as claimed in any of Claims 7 to 9, further including enhancing means (J5,J6) for decreasing input impedance presented to the sensor ($R_h$) and for increasing input impedance of the input stage.

**11.** A circuit as claimed in Claim 7 or 8, further including settling means (D9,D10,R7) for reducing the time required for the circuit to settle into steady state operating after one of the input stages is deactivated and another of the input stages is activated.

**Revendications**

**1.** Circuit comprenant une première source de courant constant (J1) pour fournir un courant de polarisation à un capteur magnéto-résistif ($R_h$), et des moyens d'amplification (11,12,13,14) comportant un étage d'entrée (11,13) qui répondent au courant circulant à travers le capteur ($R_h$) de manière à produire, par des moyens de sortie, un signal de sortie amplifié représentant la variation de résistance du capteur ($R_h$) résultant des variations du champ magnétique auquel le capteur ($R_h$) est exposé, et des moyens de réaction (14),
caractérisé en ce que les moyens de réaction (14) sont reliés à l'étage d'entrée (11,13) et aux moyens de sortie (12) pour ajuster la réponse de fréquence du circuit, l'étage d'entrée (11,13) comprenant au moins deux transistors (T1,T2) couplés en une première configuration de paire différentielle, le capteur ($R_h$) étant connecté entre l'émetteur d'un (T2) des deux transistors (T1,T2) et la première source de courant constant (J1), l'émetteur de l'autre transistor (T1) étant également relié à la première source de courant constant (J1),
et en ce que les moyens de sortie (12) comprennent au moins deux transistors (T7,T8) couplés en une deuxième configuration de paire différentielle, les collecteurs respectifs de ces transistors (T7,T8) étant reliés aux bases respectives des transistors (T1,T2) de la première paire différentielle pour corriger les variations de niveau de tension aux bases des transistors (T1,T2) de la dite première paire différentielle, et un premier et un deuxième transistors suiveurs (T5,T6) couplés aux collecteurs respectifs des transistors (T1,T2) de ladite première paire différentielle, pour appliquer les variations de niveau de tension produites dans l'étage d'entrée (11,13) à la deuxième paire différentielle, ce qui supprime sensiblement toute tension de décalage de courant continu dans le signal de sortie amplifié.

2. Circuit suivant la revendication 1, dans lequel l'étage d'entrée (11,13) comprend des moyens (11) pour soustraire un signal d'erreur, produit par les moyens de réaction (14), d'un signal représentant le courant qui circule à travers le capteur ($R_h$).

3. Circuit suivant la revendication 1 ou la revendication 2, dans lequel la deuxième paire différentielle envoie un signal à l'étage d'entrée (11,13).

4. Circuit suivant l'une quelconque des revendications précédentes, dans lequel l'étage d'entrée comprend des moyens de division du signal représentant le courant qui circule à travers le capteur ($R_h$) par un signal représentant la résistance d'état stable du capteur ($R_h$).

5. Circuit suivant la revendication 1, dans lequel le courant fourni par la première source de courant constant (J1) a une valeur moyenne constante dans le temps, et les transistors (T1,T2) de la première paire différentielle amplifient les écarts de courant, par rapport à la valeur moyenne constante, du courant qui circule à travers le capteur ($R_h$).

6. Circuit suivant la revendication 5, dans lequel ladite deuxième paire différentielle (T7,T8) est reliée à une deuxième source de courant constant (J2), et lesdits transistors suiveurs (T5,T6) sont reliés à une troisième et une quatrième sources de courant constant (J3,J4) respectivement.

7. Circuit suivant la revendication 6, comprenant une pluralité d'étages d'entrée (g1,g2) reliés à des moyens de sélection pour activer un étage individuel de la pluralité d'étages d 'entrée et désactiver tous les étages d'entrée restants.

8. Circuit suivant la revendication 7, comprenant des moyens de suppression des phénomènes transitoires, pour supprimer les phénomènes transitoires produits par la désactivation d'un étage et l'activation d'un autre étage de la pluralité d'étages d'entrée.

9. Circuit suivant la revendication 7 ou la revendication 8, dans lequel les moyens de suppression des phénomènes transitoires comprennent :

une cinquième source de courant constant (J9) reliée à l'émetteur d'un transistor de ladite paire différentielle (T7,T8) ; et

une résistance (R7) et une première et une deuxième diodes (D9,D10), chacune étant reliée en parallèle à l'autre et entre la deuxième (J2) et une cinquième (J9) sources de courant constant, la cathode de la première diode (D10) et l'anode de la deuxième diode (D9) étant reliées à la cinquième source de courant constant (J9).

10. Circuit suivant l'une quelconque des revendications 7 à 9, comprenant en outre des moyens de renforcement (J5,J6) pour diminuer l'impédance d'entrée présentée au capteur ($R_h$) et diminuer l'impédance d'entrée de l'étage d'entrée.

11. Circuit suivant la revendication 7 ou 8, comprenant en outre des moyens de stabilisation (D9,D10, R7) pour réduire le temps nécessaire à la stabilisation du circuit à un fonctionnement en régime établi, après désactivation d'un des étages d'entrée et activation d'un autre des étages d'entrée.

**Patentansprüche**

1. Schaltung mit einer ersten Konstantstromquelle (J1) zur Versorgung eines magnetoresistiven Sensors ($R_h$) mit einem eingeprägten Strom, mit Verstärkermitteln (11, 12, 13, 14), die eine auf den durch den Sensor ($R_h$) fließenden Strom ansprechende Eingangsstufe (11, 13) besitzen, um durch ein Ausgangsmittel ein verstärktes Ausgangssignal zu erzeugen, welches die Widerstandsänderung des Sensors ($R_h$) repräsentiert, die von den Änderungen des Magnetfelds herrührt, dem der Sensor ($R_h$) ausgesetzt ist, und mit einem Rückkopplungsmittel (14),
dadurch gekennzeichnet, daß das Rückkopplungsmittel (14) zur Einstellung des Frequenzganges der Schaltung an die Eingangsstufe (11, 13) und an das Ausgangsmittel (12) geschaltet ist, wobei die Eingangsstufe (11, 13) zumindest zwei Transistoren (T1, T2) enthält, die in einer ersten Differential-Paaranordnung geschaltet sind, hiebei der Sensor ($R_h$) zwischen den Emitter eines Transistors (T2) des Paares (T1, T2) und die erste Konstantstromquelle (J1) geschaltet ist und der Emitter des anderen Transistors (T1) gleichfalls an die erste Konstantstromquelle (J1) geschaltet ist
und daß das Ausgangsmittel (12) zumindest zwei, in einer zweiten Differential-Paaranordnung geschaltete Transistoren (T7, T8) besitzt, die entsprechenden Kollektoren dieser Transistoren (T7, T8) an die entsprechenden Basen der Transistoren (T1, T2) des ersten Differentialpaares geschaltet sind, um Spannungspegeländerungen an den Basen der Transistoren (T1, T2) des ersten Differentialpaares zu korrigieren, und erste und zweite Folgertransistoren (T5, T6) an die entsprechenden Kollektoren der Transistoren (T1, T2) des ersten Differentialpaares geschaltet sind, um in der Eingangsstufe (11, 13) erzeugte Spannungspegeländerungen an das zweite Differentialpaar zu koppeln und hiedurch jede Offset-Gleichspannung in dem verstärkten Ausgangssignal im wesentlichen zu eliminieren.

**2.** Schaltung nach Anspruch 1, bei welcher die Eingangsstufe (11, 13) ein Mittel (11) besitzt, um ein von dem Rückkopplungsmittel (14) erzeugtes Fehlersignal von einem den durch den Sensor ($R_h$) fließenden Strom repräsentierenden Signal zu subtrahieren.

**3.** Schaltung nach Anspruch 1 oder 2, bei welcher das zweite Differentialpaar ein Signal nach vorne zu der Eingangsstufe (11, 13) liefert.

**4.** Schaltung nach einem der vorgehenden Ansprüche, bei welcher die Eingangsstufe ein Mittel aufweist, um das Signal, welches den durch den Sensor ($R_h$) fließenden Strom repräsentiert, durch ein Signal zu dividieren, welches den stationären Widerstand des Sensors ($R_h$) repräsentiert.

**5.** Schaltung nach Anspruch 1, bei welcher der von der ersten Konstantstromquelle (J1) gelieferte Strom einen konstanten zeitlichen Mittelwert besitzt und die Transistoren (T1, T2) des ersten Differentialpaares Stromabweichungen von dem konstanten zeitlichen Mittelwert des durch den Sensor ($R_h$) fließenden Stroms verstärken.

**6.** Schaltung nach Anspruch 5, bei welcher das zweite Differentialpaar (T7, T8) an eine zweite Konstantstromquelle (J2) geschaltet ist und die Folgertransistoren (T5, T6) je an dritte bzw. vierte Konstantstromquellen (J3, J4) geschaltet sind.

**7.** Schaltung nach Anspruch 6, mit einer Mehrzahl von Eingangsstufen (g1, g2), die an Auswahlmittel angeschlossen sind, um eine bestimmte aus der Mehrzahl von Eingangsstufen zu aktivieren und alle verbleibenden Eingangsstufen zu deaktivieren.

**8.** Schaltung nach Anspruch 7, mit Einschwingunterdrückungsmitteln, um Einschwingvorgänge zu unterdrücken, die durch das Deaktivieren der einen und das Aktivieren einer anderen der Mehrzahl von Eingangsstufen hervorgerufen werden.

**9.** Schaltung nach Anspruch 7 oder 8, bei welcher die Einschwingunterdrückungsmittel aufweisen:
eine fünfte Konstantstromquelle (J9), die an den Emitter eines (Transistors) des Differentialpaares (T7, T8) geschaltet ist; und
einen Widerstand (R7) und eine erste und zweite Diode (D9, D10), die alle parallel zueinander und zwischen die zweite (J2) und eine fünfte (J9) Konstantstromquelle geschaltet sind, wobei die Kathode der ersten Diode (D10) und die Anode der zweiten Diode (D9) an die fünfte Konstantstromquelle (J9) geschaltet sind.

**10.** Schaltung nach einem der Ansprüche 7 bis 9, welche weiters Anhebungsmittel (J5, J6) besitzt, um die dem Sensor ($R_h$) angebotene Eingangsimpedanz zu verringern und um die Eingangsimpedanz der Eingangsstufe zu erhöhen.

**11.** Schaltung nach Anspruch 7 oder 8, welche ferner Beruhigungsmittel (D9, D10, R7) besitzt, um jene Zeit zu verringern, die erforderlich ist, daß die Schaltung in einen stationären Betriebszustand übergeht, nachdem eine der Eingangsstufen deaktiviert und eine andere der Eingangsstufen aktiviert wurde.

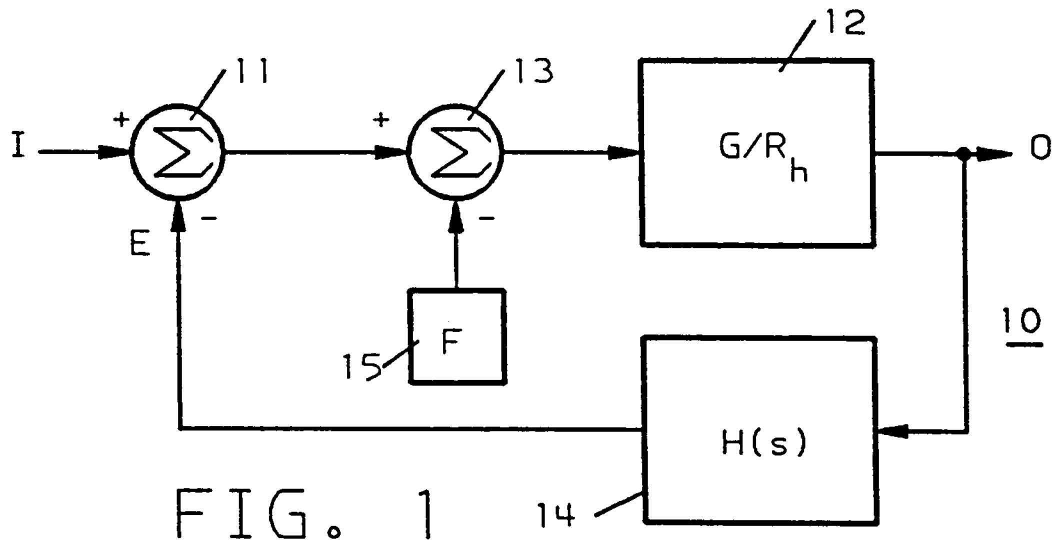
I
+
E
-
11
+
-
13
12
G/R_h
O
F
15
10
H(s)
14

FIG. 1

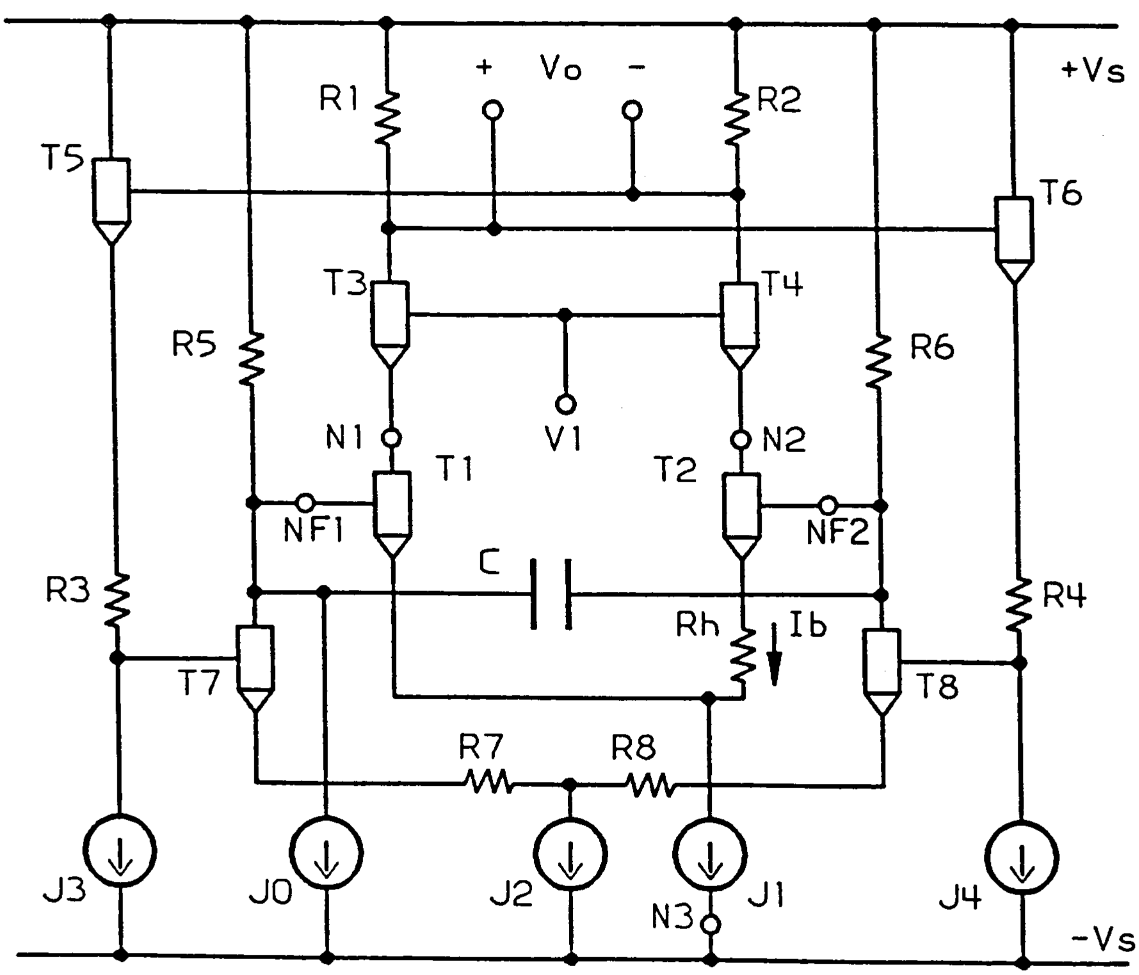
+Vs
+
Vo
-
R1
R2
T5
T6
T3
T4
R5
R6
V1
N1
N2
T1
T2
NF1
NF2
C
R3
R4
Rh
Ib
T7
T8
R7
R8
J3
J0
J2
J1
J4
N3
-Vs

FIG. 2A

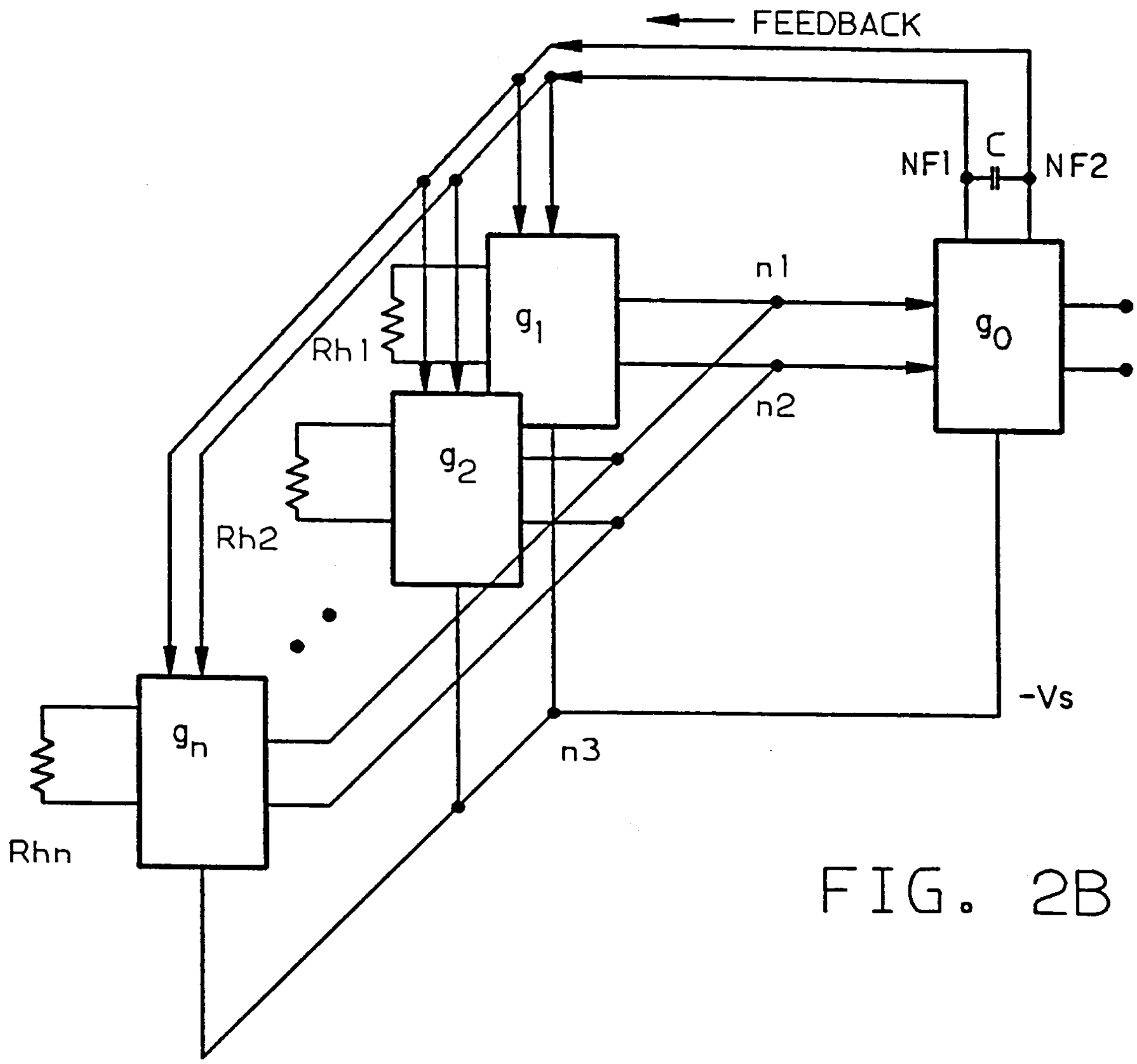


FIG. 2B

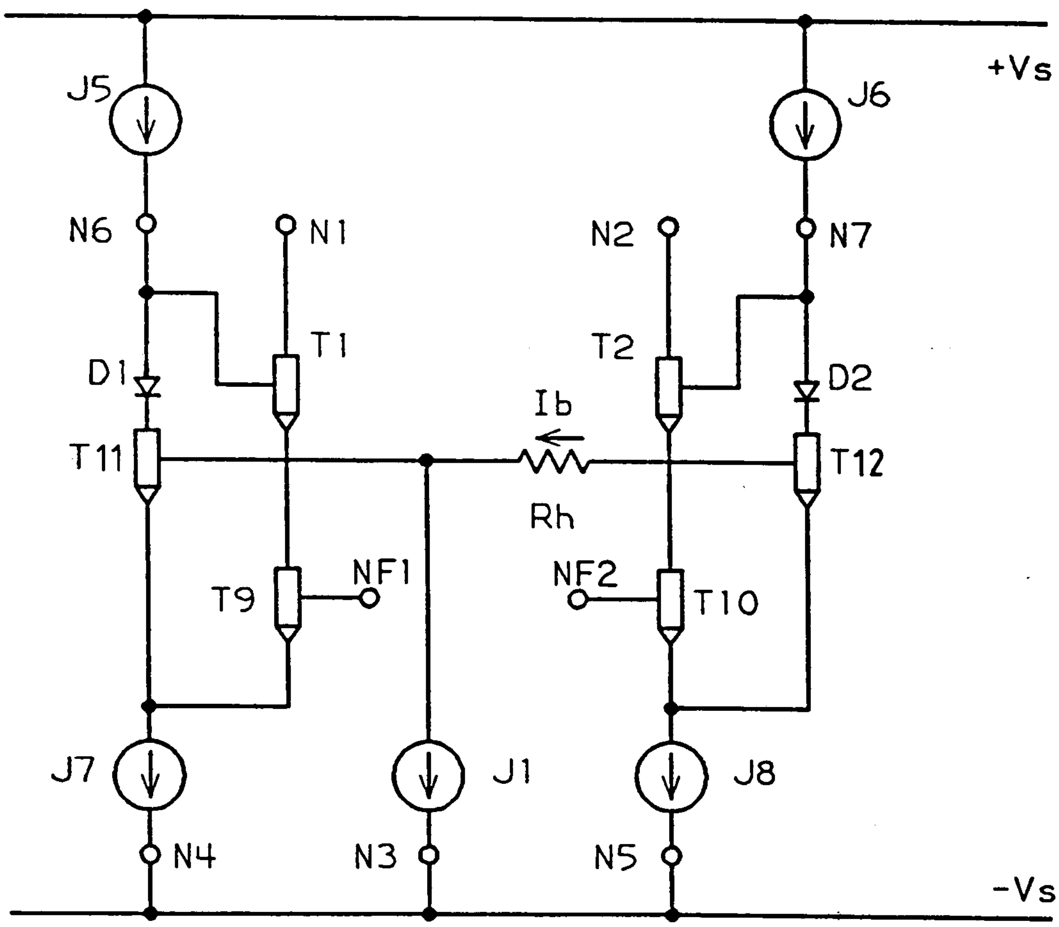
+Vs
J5
J6
N6
N1
N2
N7
T1
T2
D1
D2
Ib
T11
T12
Rh
NF1
NF2
T9
T10
J7
J1
J8
N4
N3
N5
-Vs

FIG. 3

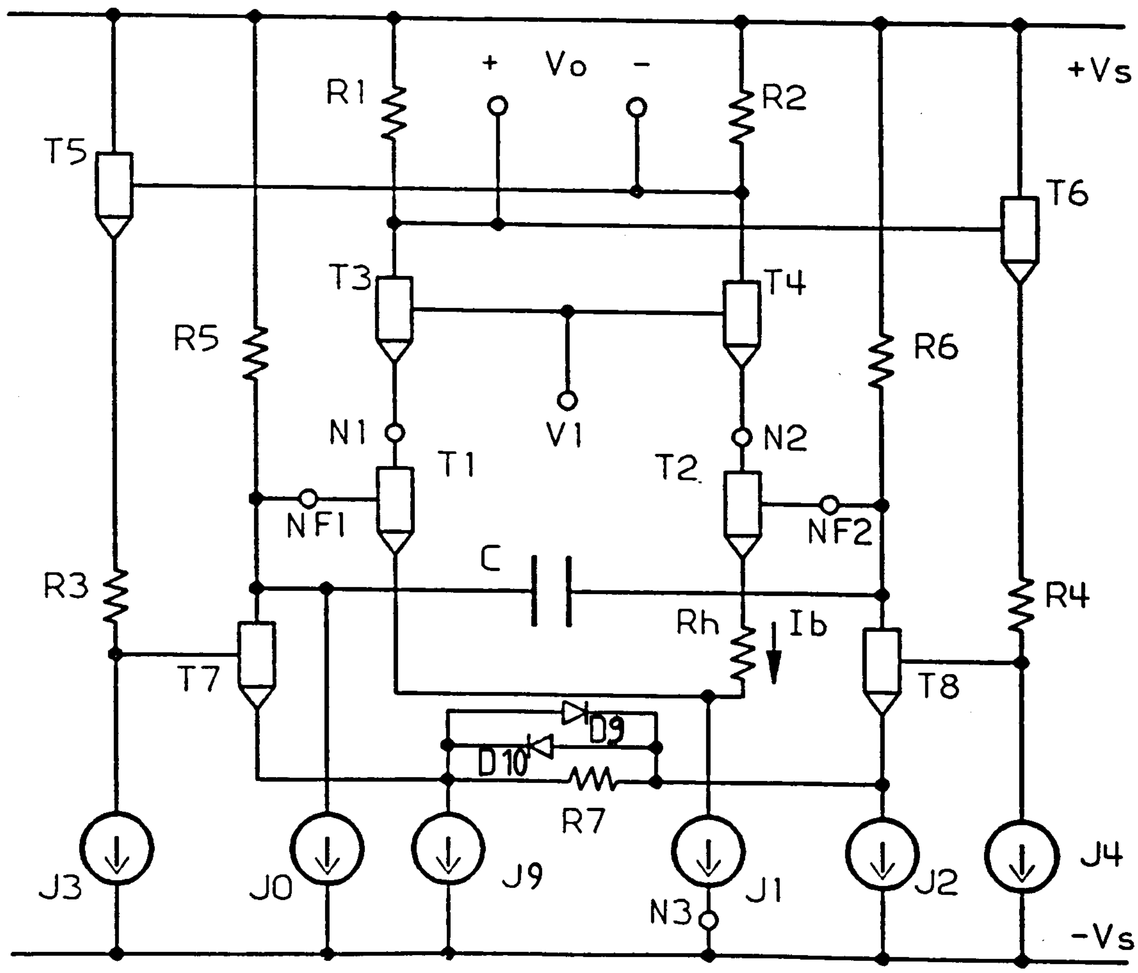

+ Vo -
+Vs
-Vs
R1
R2
R3
R4
R5
R6
R7
Rh
T1
T2
T3
T4
T5
T6
T7
T8
N1
N2
N3
NF1
NF2
V1
C
Ib
D9
D10
J0
J1
J2
J3
J4
J9


FIG. 4

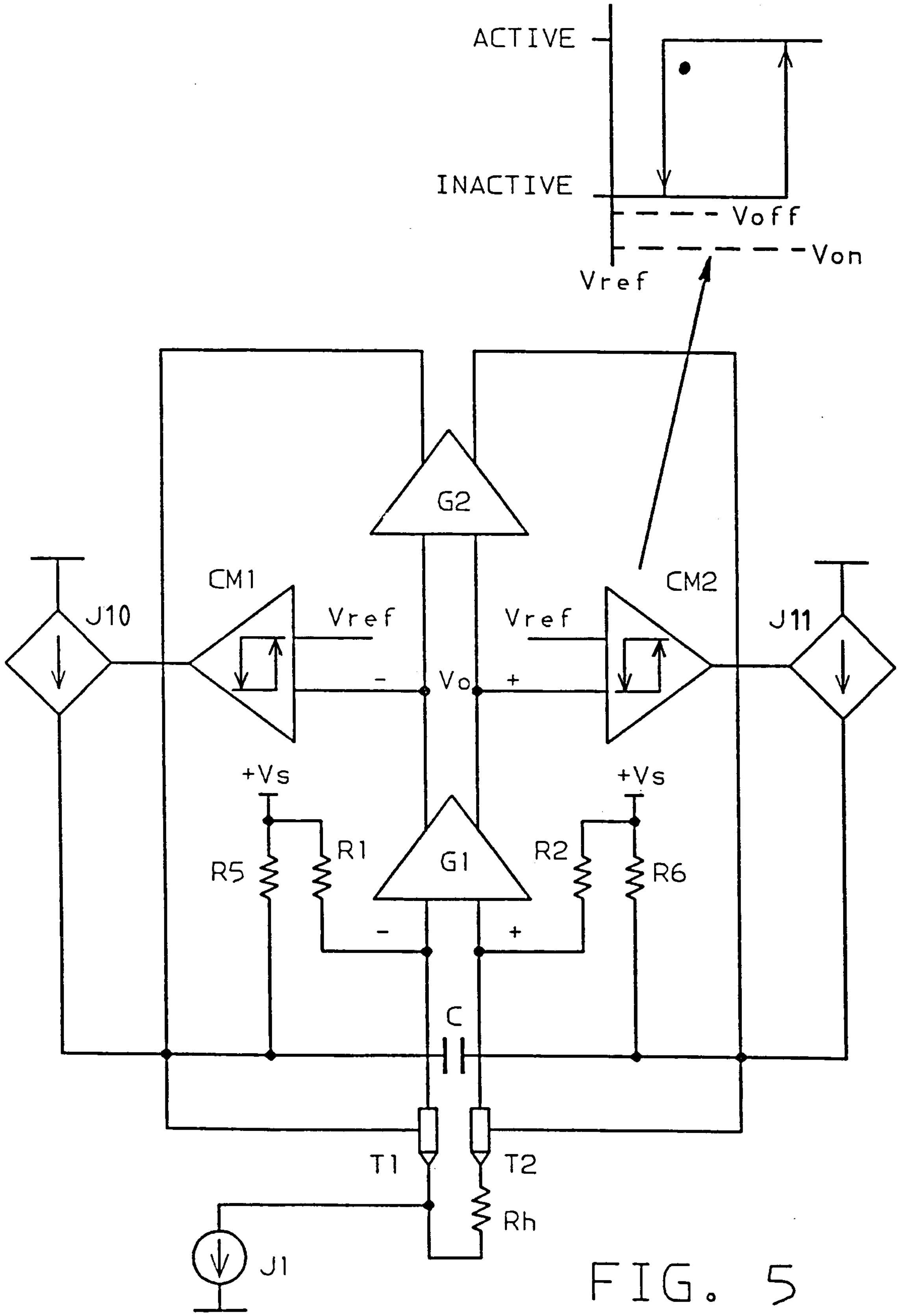
ACTIVE
INACTIVE
Voff
Von
Vref
G2
CM1
CM2
J10
J11
Vref
Vref
Vo
+Vs
+Vs
R1
R2
R5
R6
G1
C
T1
T2
Rh
J1

FIG. 5

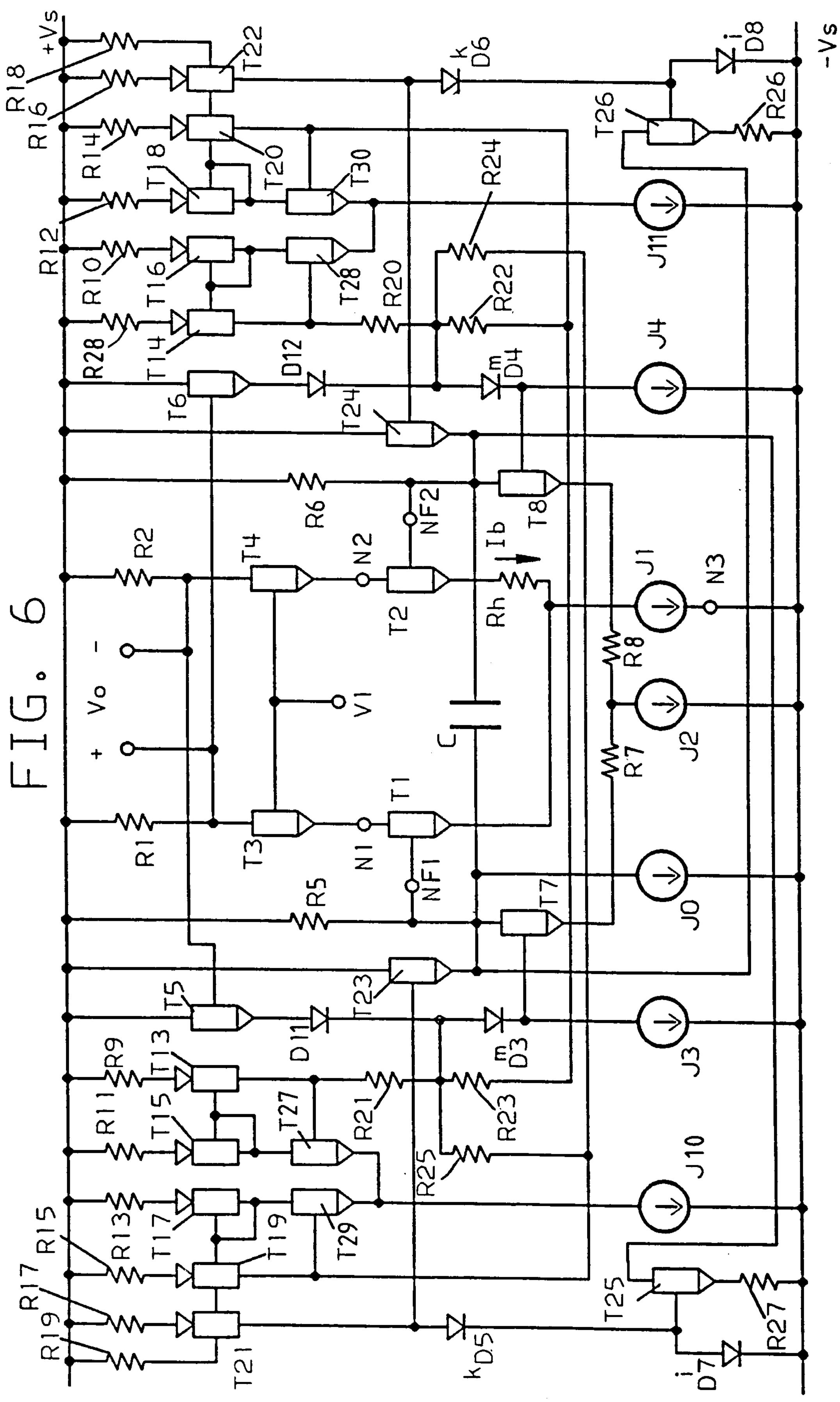
+Vs
-Vs
+ Vo -
V1
R1 R2 R5 R6 R7 R8 R9 R10 R11 R12 R13 R14 R15 R16 R17 R18 R19 R20 R21 R22 R23 R24 R25 R26 R27 R28
Rh
Ib
C
T1 T2 T3 T4 T5 T6 T7 T8 T13 T14 T15 T16 T17 T18 T19 T20 T21 T22 T23 T24 T25 T26 T27 T28 T29 T30
N1 N2 N3
NF1 NF2
D3 D4 D5 D6 D7 D8 D11 D12
k m i
J0 J1 J2 J3 J4 J10 J11

FIG. 6

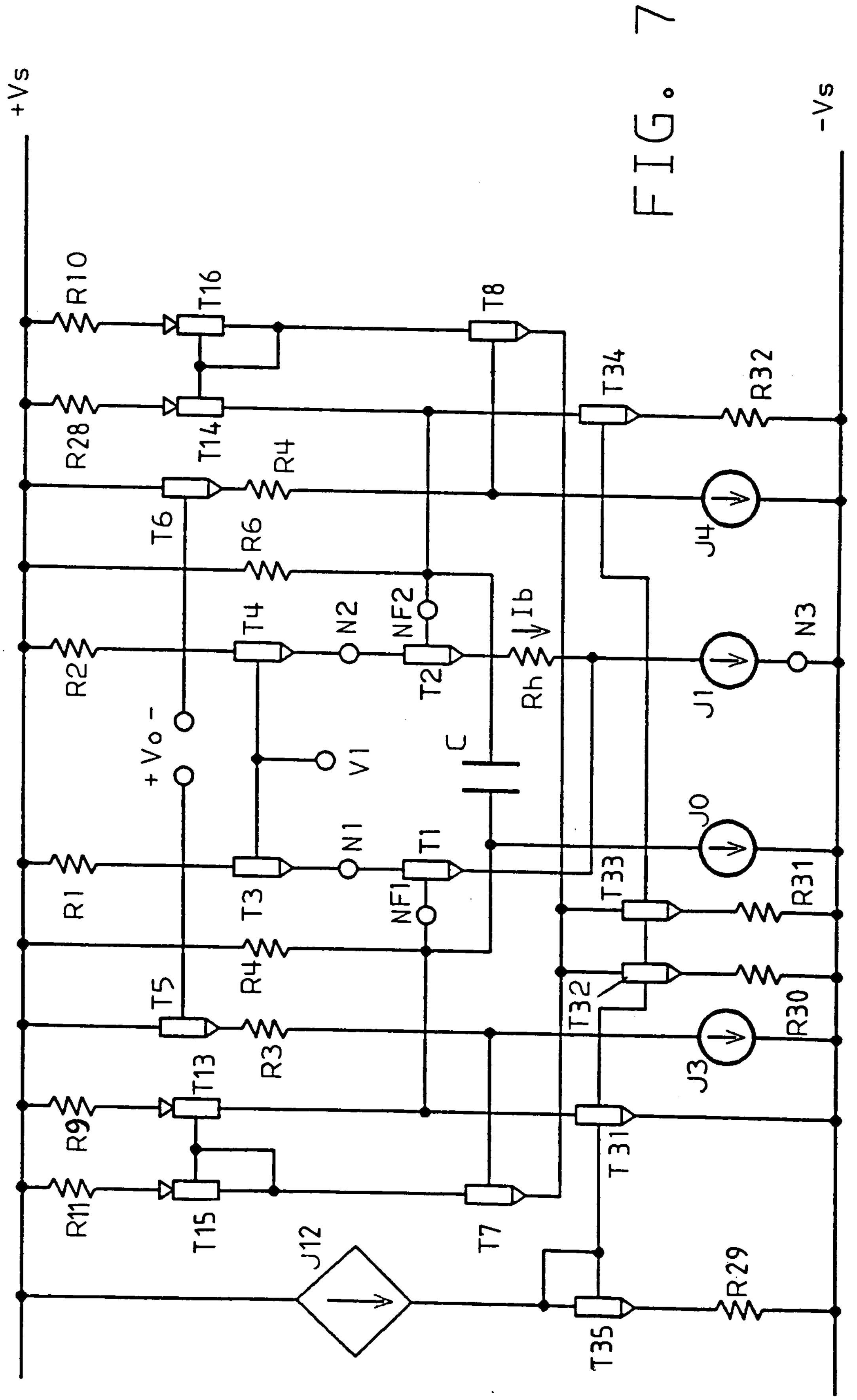
+Vs
-Vs
R10
T16
R28
T14
T8
T34
R32
T6
R4
J4
R6
NF2
N2
T4
R2
T2
Ib
Rh
N3
J1
+Vo -
V1
C
J0
R1
T3
N1
T1
NF1
T33
R31
R4
T5
T32
R30
R3
J3
T13
R9
T31
R11
T15
J12
T7
R29
T35

FIG. 7